(19) Europäisches Patentamt
European Patent Office
Office européen des brevets

(11) **EP 2 853 911 A1**

(12) **EUROPEAN PATENT APPLICATION**

(43) Date of publication:
01.04.2015 Bulletin 2015/14

(51) Int Cl.:
*G01R 35/00* (2006.01)  *G01R 27/28* (2006.01)

(21) Application number: 14186464.5

(22) Date of filing: 25.09.2014

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: 25.09.2013 US 201361882283 P
01.05.2014 US 201414267697

(71) Applicant: **Tektronix, Inc.**
**Beaverton, Oregon 97077-0001 (US)**

(72) Inventors:
• **Pickerd, John**
  **Beaverton, OR 97077-0001 (US)**
• **Tan, Kan**
  **Beaverton, OR 97077-0001 (US)**
• **Knierim, Daniel**
  **Beaverton, OR 97077-0001 (US)**

(74) Representative: **Clarke, Jeffrey David**
**HGF Limited**
**Fountain Precinct**
**Balm Green**
**Sheffield S1 2JA (GB)**

(54) **Two port vector network analyzer using de-embed probes**

(57)    A test and measurement system including a device under test (114), two de-embed probes (102, 104) connected to the device under test, and a test and measurement instrument (100) connected to the two de-embed probes. The test and measurement instrument includes a processor configured to determine the S-parameter set of the device under test based on measurements from the device under test taken by the two de-embed probes.

FIG. 1

**Description**

TECHNICAL FIELD

The disclosed technology relates generally to signal acquisition systems and, more particularly, to a system for measuring the scattering parameters (S-parameters) of a device under test.

BACKGROUND

Typical probes used for signal acquisition and analysis devices such as digital storage oscilloscopes (DSOs) and the like have an impedance associated with them which varies with frequency. For example, a typical probe may have an impedance of 100K to 200K Ohms at DC, which impedance drops towards 200 ohms at 1.5 GHz. Higher bandwidth probes drop to even lower impedance values. This drop in impedance as frequency increases, coupled with the fact that many devices under test being probed have an output impedance in the range of 25-150 ohms, results in a significant loading of the device under test by the probe. As such, an acquired waveform received via a probe loading such a device under test may not accurately represent the voltage of the device under test prior to the introduction of the probe.

Traditionally, a vector network analyzer or a time-domain reflectometer (TDR) system with a sampling oscilloscope have been required to measure the scattering parameters (S-parameters) for a two-port network characterization of a device under test in order to de-embed the effects of the probes. However, vector network analyzers and TDR systems are expensive.

What is needed is a more cost effective system that allows a user to view fully de-embedded representations of waveforms at the probe tip.

SUMMARY

Certain embodiments of the disclosed technology include a method for determining an S-parameter set of a device under test using a test and measurement instrument including measuring an impedance of a signal generator with a first de-embed probe, measuring an input voltage to the device under test with the first de-embed probe connected to the input of the device under test, measuring an output voltage from the device under test with a second de-embed probe connected to the output of the device under test, measuring three loads of the device under test with the first de-embed probe connected to the input of the device under test and the second de-embed probe connected to the output of the device under test; and calculating the S-parameter set of the device under test based on the impedance of the signal generator, the input voltage to and the output voltage from the device under test, and the measured three loads of the device under test.

Certain embodiments of the disclosed technology include a test and measurement system for measuring an S-parameters set of a device under test, including a signal generator, the device under test, a first de-embed probe configured to measure an impedance of the signal generator and an input voltage of the device under test, a second de-embed probe configured to measure an output voltage of the device under test and an impedance of the device under test, wherein the first de-embed probe and the second de-embed probe are configured to measure at least three loads when both the first de-embed probe and the second de-embed probe are connected to the device under test, and a processor configured to calculate the S-parameter set of the device under test based on the impedance of the signal generator, the input voltage and the output voltage of the device under test, and the measured three loads of the device under test.

Certain embodiments of the disclosed technology also include a test and measurement system including a device under test, two de-embed probes connected to the device under test and configured to take measurements of the device under test, and a processor configured to receive the measurements taken by the two de-embed probes and to determine the S-parameter set of the device under test based on the measurements of the device under test.

BRIEF DESCRIPTION OF THE DRAWINGS

FIGS. 1-4 illustrates block diagrams of a test and measurement system used to determine S-parameter sets of a device under test according to embodiments of the disclosed technology.

FIG. 5 illustrates an alternative block diagram of a test and measurement system used to determine S-parameter sets of a device under test according to embodiments of the disclosed technology.

FIGS. 6-7 illustrates another alternative block diagram of a test and measurement system used to determine S-parameter sets of a device under test according to other embodiments of the disclosed technology.

FIG. 8 illustrates a signal flow graph according to the test and measurement system shown in FIGS. 1-4.

FIG. 9 illustrates a signal flow graph according to other embodiments of the test and measurement instrument.

## DETAILED DESCRIPTION

In the drawings, which are not necessarily to scale, like or corresponding elements of the disclosed systems and methods are denoted by the same reference numerals.

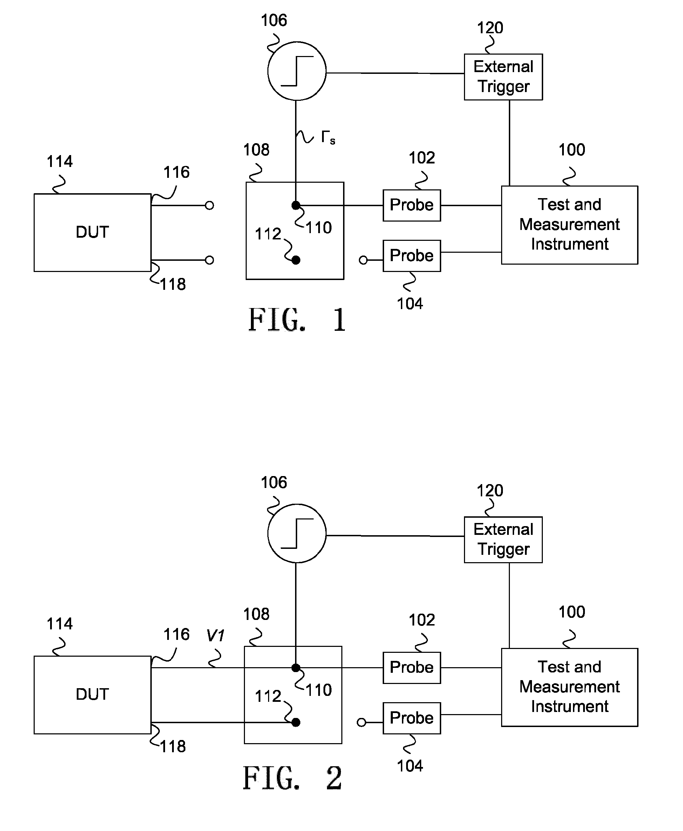

FIG. 1 depicts a test and measurement system including a test and measurement instrument 100, such as a digital storage oscilloscope, connected to two de-embed probes 102 and 104 to measure the S-parameters of a device under test 114. The test and measurement system shown in FIGS. 1-4 allows a test and measurement instrument, such as a digital storage oscilloscope, to act as a calibrated vector network analyzer measurement system. That is, the test and measurement system is capable of measuring all four S-parameters of a two-port device under test 114. The test and measurement instrument 100 includes a processor (not shown) to calculate the various computations discussed below.

De-embed probes are described in U.S. Patent Application Publication No. 2005/0185768 A1 titled CALIBRATION METHOD AND APPARATUS, U.S. Patent Application Publication No. 2005/0094746 A1 titled CHARACTERISTIC MEASUREMENT SYSTEM FOR A DIGITAL MODULATION SIGNAL TRANSMISSION CIRCUIT, U.S. Patent Application Publication No. 2007/0276614 A1 titled DE-EMBED METHOD FOR MULTIPLE PROBES COUPLED TO A DEVICE UNDER TEST, and U.S. Patent No. 7,405,575 B2 titled SIGNAL ANALYSIS SYSTEM AND CALIBRATION METHOD FOR MEASURING THE IMPEDANCE OF A DEVICE UNDER TEST, each of which is herein incorporated by reference in its entirety.

The de-embed probes 102 and 104 contain loads that can be placed across the inputs of each probe under control of the test and measurement instrument 100. This allows for a fully calibrated and de-embedded measurement at the probe inputs. Although not shown, probes 102 and 104 contain controllers that interact with a processor or controller (not shown) of the test and measurement instrument 100 to control the various switches (not shown) within probes 102 and 104 so that different loads can be placed across the inputs of each probe.

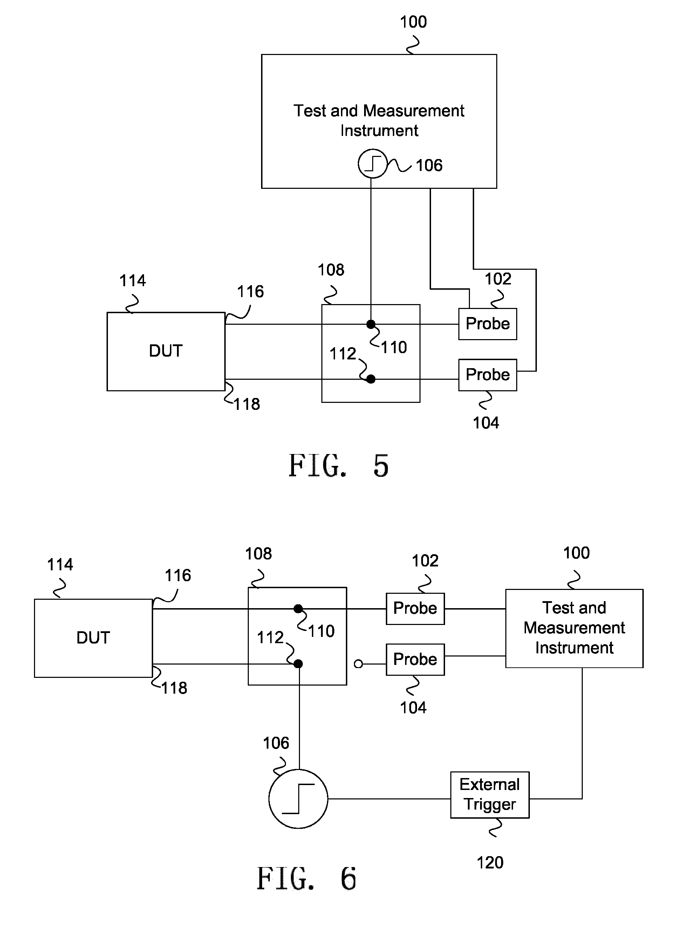

The test and measurement system of FIG. 1 also includes a signal generator 106. As shown in FIG. 1, the signal generator 106 may be an external signal generator. However, as shown in FIG. 5, the signal generator 106 may also be internal to the test and measurement instrument 100. Preferably, the signal generator 106 is a step signal generator. However, other types of signal generators 106 may be used. For example, a sine wave generator could be used and stepped through each frequency of interest. The sine wave generator may provide a better signal-to-noise ratio.

A test fixture 108 provides connection ports, port one 110 and port two 112, for connection to the device under test 114, the signal generator 106 and the de-embed probes 102 and 104. The test fixture 108 can be custom to the type of device under test 110 used. For example, if the device under test 114 is a cable, the test fixture 108 would contain connectors to connect to the cable device under test. The text fixture 108 could also contain a switching arrangement to move the test signal from one cable pair to another cable pair as the testing progresses.

FIGS. 1-4 illustrate the calibration process to determine the S-parameters of the device under test 114. The below described calibration procedure may be manual, partially automated or fully automated.

Initially, probe 102 and signal generator 106 are connected to port one 110 so the probe 102 may measure the impedance of the signal generator 106 as a function of frequency. The probe 102 is connected to the signal generator 106 at the reference plane of the signal generator 106, which is the point at which the S-parameters of the device under test 114 are measured at the signal generator 106 end. An external trigger 120 is connected to an external trigger input of the test and measurement instrument 100. External trigger 120 is also connected to the signal generator 106. The external trigger 120 triggers the signal generator 106 via a signal from the test and measurement instrument 100, or vice versa.

When probe 102 and signal generator 106 are connected to port one 110 as shown in FIG. 1, two acquisitions are taken with two different de-embed probe loads in probe 102, and test and measurement instrument 100 can calculate the reflection coefficient parameter $\Gamma_s$ for the signal generator 106 based on these acquisitions. As seen in FIG. 1, the device under test 114 is not connected to port one 110 during this measurement. However, a cable connector mounted on the test fixture 108 may be attached and therefore the S-parameters must have been previously measured and stored. Its effects can then be de-embedded out of the signal generator reflection coefficient parameter $\Gamma_s$.

The input voltage, $V1$, to the device under test 114 from signal generator 106 is measured by connecting the input port 116 of the device under test 114 to port one 110 and connecting the output port 118 of the device under test 114 to port two 112. Probe 102 is connected to port one 110. Probe 104 remains unconnected to port two 112 for this measurement. In this configuration shown in FIG. 2, the de-embed acquisitions are taken to compute the de-embedded input voltage, $V1$, into the input port 116 of the device under test 114.

To acquire the output voltage, $V2$, at the output port 118 of the device under test 114 probe 102 from port one 110 of the test fixture 108 is removed and probe 104 is connected to port two 112 of the test fixture 108. Again, the necessary de-embed acquisitions are acquired and $V2$ is computed.

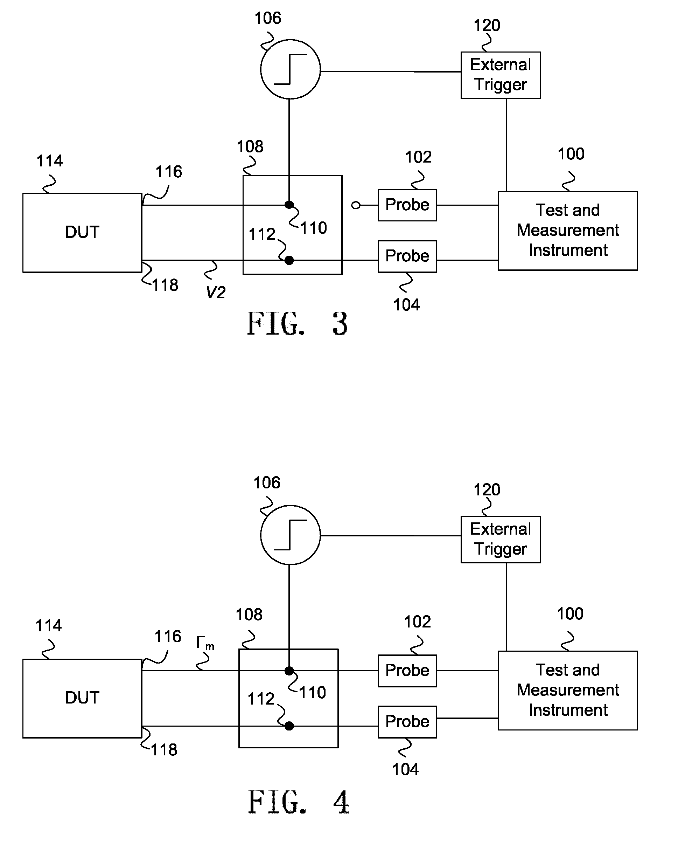

As shown in FIG. 4, both probes 102 and 104 are connected to port one 110 and port two 112, respectively, while the device under test 114 is also connected. In this configuration, three different loads on probe 104 at port two 112 are switched in by the test and measurement instrument 100 while acquisitions by probe 102 into port one 110 are acquired. The three measured loads by probe 102 on port one 110 are represented by $\Gamma_{m1}$, $\Gamma_{m2}$, and $\Gamma_{m3}$.

The measurements of $\Gamma_s$, $V1$, $V2$, $\Gamma_{m1}$, $F_{m2}$, and $\Gamma_{m3}$ can be obtained in any order as long as the probes 102 and 104 and the device under test 114 are configured as discussed above for the acquisitions. In some embodiments, both probes 102 and 104 may stay connected for most of the measurements, as will be discussed in further detail below.

Once, $\Gamma_s$, $V1$, $V2$, $\Gamma_{m1}$, $\Gamma_{m2}$, and $\Gamma_{m3}$ have been measured, the S-parameters of the device under test 114 can then be computed based on the measurements of $\Gamma_s$, $V1$, $V2$, $\Gamma_{m1}$, $\Gamma_{m2}$, and $\Gamma_{m3}$.

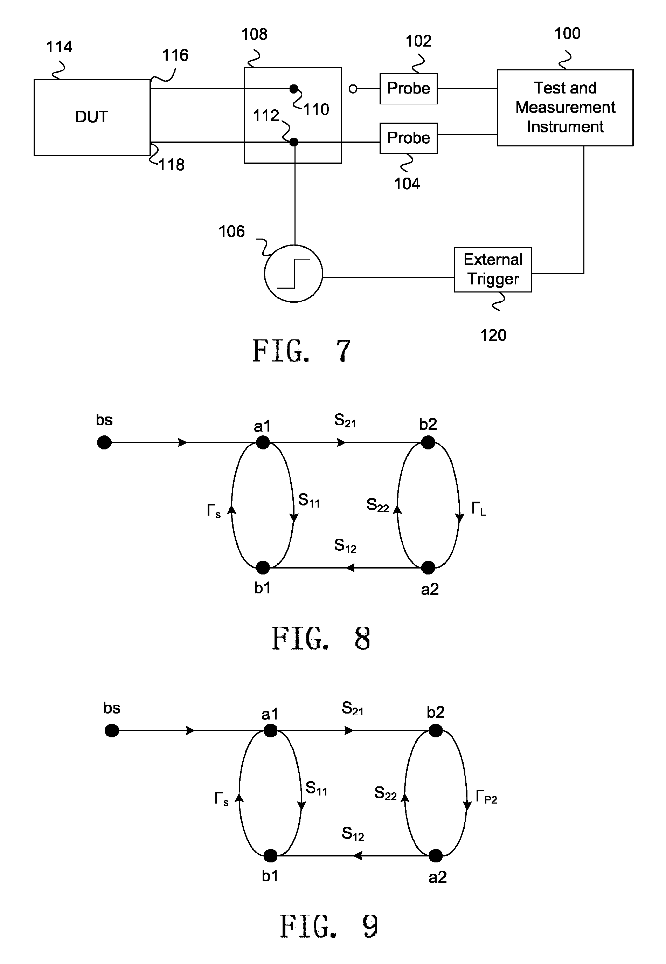

FIG. 8 illustrates a signal flow graph to represent the test and measurement system discussed above in FIGS. 1-4. The signal generator is represented by $b_s$ and $\Gamma_s$. The load value $\Gamma_L$ is either part of the de-embed probe used or a load in the test fixture. The remaining parameters $S_{11}$, $S_{12}$, $S_{21}$, $S_{22}$ represent the two port device under test 114. The signal flow graph of Fig. 8 is used to derive some of the following equations.

The value of input voltage to the device under test is $V1$ and the output voltage from the device under test 114 is $V2$. Both can be measured directly using de-embed probes 102 and 104 as discussed above. Equations (1) and (2) are derived from the signal flow graph shown in Fig. 8.

$$V1 = a1 + b1 \tag{1}$$

$$V2 = a2 + b2 \tag{2}$$

The following equations (3), (4), and (5) describe the relationship of S-parameters in the two port network:

$$\Gamma_{m1} = Ss_{11} + \frac{S_{12} \cdot S_{21} \cdot \Gamma_{c1}}{1 - S_{22} \cdot \Gamma_{c1}} \tag{3}$$

$$\Gamma_{m2} = Ss_{11} + \frac{S_{12} \cdot S_{21} \cdot \Gamma_{c2}}{1 - S_{22} \cdot \Gamma_{c2}} \tag{4}$$

$$\Gamma_{m3} = Ss_{11} + \frac{S_{12} \cdot S_{21} \cdot \Gamma_{c3}}{1 - S_{22} \cdot \Gamma_{c3}} \tag{5}.$$

These equations represent the measured loads when the device under test 114 and probes 102 and 104 are all connected to port one 110 and port two 112 of the test fixtures as seen in FIG. 4.

The three equations, (3), (4), and (5) may be written to solve for $Ss_{11}$, $S_{22}$, and $S_{12} \cdot S_{21}$. The values of $\Gamma_{c1}$, $\Gamma_{c2}$, and $\Gamma_{c3}$ are known from the stored S-parameters in the de-embed probe 104 and test and measurement instrument. These parameters are measured at manufacturing of the test and measurement instrument and the probes and would be stored in the memories of the test and measurement instruments and the probes. The value of $Ss_{11}$ is the parameter for both the signal generator 106 and the device under test 114 input port 116 in parallel.

Equations (3), (4), and (5) can be solved by starting with their general form and multiplying out the denominator on the right side of the equal sign to obtain (6):

Let:

$$\Gamma_m - S_{22} \cdot \Gamma_m \cdot \Gamma_c = Ss_{11} - Ss_{11} \cdot S_{22} \cdot \Gamma_c + S_{12} \cdot S_{21} \cdot \Gamma_c \tag{6}$$

Then rearrange (6) to obtain (7):

$$\Gamma_m = Ss_{11} - Ss_{11} \cdot S_{22} \cdot \Gamma_c + S_{12} \cdot S_{21} \cdot \Gamma_c + S_{22} \cdot \Gamma_m \cdot \Gamma_c \tag{7}$$

Then rearrange (7) to obtain (8):

$$\Gamma_m = \Gamma_m \cdot \Gamma_c \cdot S_{22} + Ss_{11} + (S_{12} \cdot S_{21} - Ss_{11} \cdot S_{22}) \cdot \Gamma_c \tag{8}$$

Some immediate variables are defined as follows in equations (9), (10), and (11):

$$x_1 = S_{22} \tag{9}$$

$$x_2 = Ss_{11} \tag{10}$$

$$x_3 = S_{12} \cdot S_{21} - Ss_{11} \cdot S_{22} \tag{11}$$

Now the intermediate variable in (9), (10), and (11) are substituted into (8) to obtain equations (12), (13), and (14):

$$\Gamma_{m1} = \Gamma_{m1} \cdot \Gamma_{c1} \cdot x_1 + x_2 + x_3 \cdot \Gamma_{c1} \tag{12}$$

$$\Gamma_{m2} = \Gamma_{m2} \cdot \Gamma_{c2} \cdot x_1 + x_2 + x_3 \cdot \Gamma_{c2} \tag{13}$$

$$\Gamma_{m3} = \Gamma_{m1} \cdot \Gamma_{c3} \cdot x_1 + x_2 + x_3 \cdot \Gamma_{c3} \tag{14}$$

The system of equations (12), (13), and (14) may then be put into matrix notation and solved for $x_1$, $x_2$, and $x_3$ as shown in (15).

$$\begin{bmatrix} \Gamma_{m1} \\ \Gamma_{m2} \\ \Gamma_{m3} \end{bmatrix} = \begin{bmatrix} \Gamma_{m1} \cdot \Gamma_{c1} & 1 & \Gamma_{c1} \\ \Gamma_{m2} \cdot \Gamma_{c2} & 1 & \Gamma_{c2} \\ \Gamma_{m3} \cdot \Gamma_{c3} & 1 & \Gamma_{c3} \end{bmatrix} \begin{bmatrix} x_1 \\ x_2 \\ x_3 \end{bmatrix}$$

$$(15).$$

The solution of x from b=Ax is simply x = A$^{-1}$b. Accordingly, from $x_1$, $x_2$, and $x_3$ variables $Ss_{11}$, $S_{22}$, and $S_{12} \cdot S_{21}$ can be computed from equations (9)-(11).

As mentioned above, $Ss_{11}$ is the parameter for both the signal generator 106 and the device under test 114 input port 116 in parallel. Removing the signal generator 106 impedance from $Ss_{11}$ to get the actual value for $S_{11}$ can be performed through the following equations. Equation (10) above is used and and $Ss_{11}$ is replaced with the combination for the generator and the DUT and equation (16) is then solved for $y_{dut}$.

The value of $Ss_{11}$ includes the generator as shown in the following equation (16) where the admittance of the generator is added in parallel to the admittance of the device under test 114.

$$x_2 = Ss_{11} = \frac{1 - (y_s + y_{dut})}{1 + (y_s + y_{dut})}$$

$$(16).$$

Equation (16) can be solved for $y_{dut}$ since the measured value of generator admittance, $y_s$, is known when signal generator 106 is characterized and $Ss_{11}$ was calculated above.

As discussed above, $\Gamma_s$ is the reflection coefficient of the signal generator 106 and the test fixture 108. The value of impedance when $\Gamma_s$ is measured can be computed from the following equation (18), where $Z_0$ is a reference impedance, which is typically 50 ohms.

$$Z_s = \frac{Z_0 (1 + \Gamma_s)}{1 - \Gamma_s}$$

$$(17).$$

Then,

$$y_s = \frac{1}{Z_s}$$

$$(18).$$

Then $y_{dut}$ is substituted into (19) to compute $S_{11}$.

$$S_{11} = \frac{1 - y_{dut}}{1 + y_{dut}}$$

$$(19).$$

At this point the value of $S_{11}$, $S_{22}$, and $S_{12} \cdot S_{21}$ have all been computed. The remaining task is to use these values and some additional measurement to compute $S_{21}$. If the device under test 114 is a passive system, then $S_{12} =$

$S_{21}$. However, if the device under test 114 is active, then $S_{21}$ can be solved for as shown below.

The following equations for the transfer function of $V2/V1$ are derived from the signal flow graph using Mason's rule, as is known in the art. This is the transfer function of the device under test 114 since $V2$ is the voltage at the output port and $V1$ is the voltage at the input port.

$$A_v = \frac{V2}{V1} = \frac{S_{21} \cdot \Gamma_L + S_{21}}{1 - S_{22} \cdot \Gamma_L + S_{11} - S_{11} \cdot S_{22} \cdot \Gamma_L + S_{12} \cdot S_{21} \cdot \Gamma_L}$$

(20).

Equation (18) can be solved for $S_{21}$:

$$S_{21} = (1 - S_{22} \cdot \Gamma_L + S_{11} - S_{11} \cdot S_{22} \cdot \Gamma_L + S_{12} \cdot S_{21} \cdot \Gamma_L) \cdot \frac{A_v}{\Gamma_L + 1}$$

(21).

After solving for $S_{21}$ from equation (21) use the value of $S_{12} \cdot S_{21}$ from equation (11) above to solve for $S_{12}$:

$$S_{12} = \frac{S_{12} \cdot S_{21}}{S_{21}}$$

(22).

Accordingly, from using the above equations, the complete set of S-parameters, $S_{11}$, $S_{12}$, $S_{21}$, and $S_{22}$, for the device under test 114 have been computed from the measured data. The test and measurement instrument 100 includes a processor and a memory (not shown) to store executable instructions for implementing the above discussed process for determining the S-parameter set of a device under test and for otherwise controlling the test and measurement instrument 100. The processor can also be external to the test and measurement instrument.

The above-discussed process for determining the S-parameter set of the device under test 114 only works if $S_{21}$ is generally not zero at all frequencies. If $S_{21}$ is zero at certain frequencies, as is nominally the case with an amplifier, then a modified procedure would be required. The modified procedure is shown in FIGS. 6 and 7. Initially, as shown in FIG. 6, the signal generator 106 is connected to port two 112 and the necessary acquisitions are taken to measure $V2$ without probe 104 connected to port two 112. As seen in FIG. 7, signal generator 106 and probe 104 are connected to port two 112 to measure $V1$ from probe 104. The formulas are modified as follows:

$$A_v = \frac{V2}{V1} = \frac{S_{12} \cdot \Gamma_L + S_{12}}{1 - S_{11} \cdot \Gamma_L + S_{22} - S_{22} \cdot S_{11} \cdot \Gamma_L + S_{21} \cdot S_{12} \cdot \Gamma_L}$$

(23).

Equation (23) can be solved for $S_{12}$:

$$S_{12} = (1 - S_{11} \cdot \Gamma_L + S_{22} - S_{22} \cdot S_{11} \cdot \Gamma_L + S_{21} \cdot S_{12} \cdot \Gamma_L) \cdot \frac{A_v}{\Gamma_L + 1}$$

(24).

After solving for $S_{12}$ from equation (24) use the value of $S_{12} \cdot S_{21}$ from equation (11) above to solve for $S_{21}$:

$$S_{21} = \frac{S_{12} \cdot S_{21}}{S_{12}}$$

In some embodiments of the disclosed technology, probes 102 and 104 can stay connected to the device under test 114, as shown in FIG. 4 for each device under test 114 tested. Such an embodiment would be less timing consuming for a user and there would be less chance of damage to the test fixture 108 and the device under test 114 during the probing process. This is especially advantageous for high performance probes that typically must be soldered into place.

Initially, the signal generator 106 for the system is characterized as discussed above. That is, signal generator 106 is still characterized without the device under test 114 connected to port one 110 and port two 112, as shown in FIG. 1.

Probe 104 is then connected to the test fixture at port two 112 and the device under test 114 and signal generator 106 are also connected to port one 110 and port two 112, as shown in FIG. 4. As discussed above, three different loads from the probe on port two 112 will be switched in from probe 104 while de-embed probe 102 on port one 110 makes a measurement of $\Gamma_{m1}$, $\Gamma_{m2}$, and $\Gamma_{m3}$. These three sets of measurements are used to solve for $Ss_{11}$, $S_{22}$, and $S_{12} \cdot S_{21}$ of the device under test 114, as discussed above with respect to equations (3)-(15). $S_{11}$ can be determined by removing the known $\Gamma_s$ of the signal generator 106 from the parallel combination, as discussed above with respect to equations (16) and (19).

Rather than measuring $V1$ and $V2$ as discussed above, that is, with only a single probe connected at a time, $V1$ and $V2$ can be measured with both de-embed probes 102 and 104 and the device under test 114 connected to port one 110 and port two 112. These voltages, however, include the loading effects of each probe 102 and 104 on the opposite port 110 and 112. Equation (20) above, therefore, has to be modified to include the reflection coefficient of port two 112, $\Gamma_{P2}$, replacing $\Gamma_L$. It will be assumed that the de-embed probes 102 and 104 have some known load.

The signal flow graph shown in FIG. 8 would be modified as shown in FIG. 9 to include the effects of the de-embed probes 102 and 104 loading on each port. The value of $\Gamma_{P2}$ is for the de-embed probe 104 connected to port two 112 of the device under test 114.

Equation (25) can be used to compute the value of $S_{21}$. The values of $S_{12} \cdot S_{21}$, $S_{11}$, $A_v$, and $\Gamma_{P2}$ are known based on the above discussed equations and measurements.

$$A_v = \frac{V2}{V1} = \frac{S_{21} \cdot \Gamma_{P2} + S_{21}}{1 - S_{22} \cdot \Gamma_{P2} + S_{11} - S_{11} \cdot S_{22} \cdot \Gamma_{P2} + S_{12} \cdot S_{21} \cdot \Gamma_{P2}}$$

$$(25).$$

Equation (22) can be solved for $S_{21}$:

$$S_{21} = (1 - S_{22} \cdot \Gamma_{P2} + S_{11} - S_{11} \cdot S_{22} \cdot \Gamma_{P2} + S_{12} \cdot S_{21} \cdot \Gamma_{P2}) \cdot \frac{A_v}{\Gamma_{P2} + 1}$$

$$(26).$$

Once $S_{21}$ has been determined, then $S_{12}$ can be determined by using equation (20) above. Then, the S-parameter set of the device under test 114 have been determined while leaving both probes 102 and 104 and the input 116 and output 118 of the device under test 114 connected to port one 110 and port two 112.

Although standard de-embed probes have been discussed above with respect to de-embed probes 102 and 104, the de-embed probes 102 and 104 can also alternatively be subminiature version A (SMA) input de-embed probes. A standard de-embed probe allows the reference plane for the device under test S-parameter measurement to be established directly at the connector point as desired. However, if an SMA input de-embed probe is used, the S-parameters of the portion of the test fixture 108 between the SMA probe input and up to the reference plane must be measured separately and then de-embedded out of the final measurements.

The disclosed technology is not limited to two port devices under test. That is, the disclosed technology can be used to provide S-parameter measurements for devices under test with more than two ports. This is done in a similar manner as vector network analyzers. For example, to measure the S-parameters for a three-port device under test, several two port measurements, as discussed above, are performed between any two ports while the remaining port(s) are terminated with a reference impedance, $Z_{ref}$. After all combinations of two ports have been measured through the above method, the technique is known to compute out the parameters of the three port system using the two port system parameters.

The test and measurement instrument 100 may be an oscilloscope, as discussed above. However, the test and measurement instrument 100 may also be a spectrum analyzer. Further, the test and measurement instrument 100 may include a user interface to allow a user to setup control and initiate the required processes for the test and measurement instrument to act as the vector network analyzer. As mentioned above, the test and measurement instrument 100 includes a processor and a memory (not shown) to store executable instructions for implementing the above discussed process for determining the S-parameter set of a device under test and for otherwise controlling the test and measurement instrument 100. Computer readable code embodied on a computer readable medium, when executed, causes the computer to perform any of the above-described operations. As used here, a computer is any device that can execute code. Microprocessors, programmable logic devices, multiprocessor systems, digital signal processors, personal computers, or the like are all examples of such a computer. In some embodiments, the computer readable medium can be a tangible computer readable medium that is configured to store the computer readable code in a non-transitory manner.

The following section of the description consists of numbered paragraphs simply providing statements of the invention already described herein. The numbered paragraphs in this section are not claims. The claims are set forth below in the later section headed "claims".

1. A method for determining an S-parameter set of a device under test using a test and measurement instrument, comprising measuring an impedance of a signal generator with a first de-embed probe; measuring an input voltage to the device under test with the first de-embed probe connected to the input of the device under test; measuring an output voltage from the device under test with a second de-embed probe connected to the output of the device under test; measuring three loads of the device under test with the first de-embed probe connected to the input of the device under test and the second de-embed probe connected to the output of the device under test; and calculating the S-parameter set of the device under test based on the impedance of the signal generator, the input voltage to and the output voltage from the device under test, and the measured three loads of the device under test.

2. The method of 1, wherein the measuring of the impedance of the signal generator with the first de-embed probe is performed with the device under test not connected to the first de-embed probe or the second de-embed probe.

3. The method of 2, wherein the measuring of the input voltage of the device under with the first de-embed probe is performed with the device under test not connected to the second de-embed probe.

4. The method of 3, wherein the measuring of the output voltage of the device under test with the second de-embed probe is performed with the device under test and the signal generator not connected to the first de-embed probe.

5. The method of 2, wherein the measuring of the input voltage of the device under test and the measuring of the output voltage of the device under test are performed when the first de-embed probe is connected to the input of the device under test and when the second de-embed probe is simultaneously connected to the output of the device under test.

6. The method of 1, further comprising: measuring a second impedance of the device under test and the signal generator with the second de-embed probe; and measuring a second output voltage of the device under test with the second de-embed probe connected to the output of the device under test and the signal generator, wherein the calculating step further includes calculating the S-parameter set based on the second impedance and the second output voltage from the device under test.

7. The method of 1, wherein the test and measurement instrument is a digital storage oscilloscope or a spectrum analyzer.

8. The method of 1, wherein the signal generator is a step generator.

9. A method for determining an S-parameter set of a device under test with more than two ports using a test and measurement instrument, comprising: performing the method of claim 1 on each two port combination of the more than two ports of the device under test with the remaining ports terminated with a reference impedance; and calculating the S-parameter set of the device under test based on the parameters determined for all the two port combinations.

10. A test and measurement system for measuring an S-parameters set of a device under test, comprising: a signal generator; a first de-embed probe configured to measure an impedance of the signal generator and an input voltage of the device under test; a second de-embed probe configured to measure an output voltage of the device under test and an impedance of the device under test, wherein the first de-embed probe and the second de-embed probe are configured to measure at least three loads when both the first de-embed probe and the second de-embed probe are connected to the device under test; and a processor configured to calculate the S-parameter set of the device under test based on the impedance of the signal generator, the input voltage and the output voltage of the device under test, and the measured three loads of the device under test.

11. The system of 10, further including a test fixture including a first port and a second port, wherein the first de-embed probe connects to the signal generator and the device under test through the first port, and the second de-embed probe connects to the device under test through the second port.

12. The system of 10, wherein the signal generator is located within a test and measurement instrument.

13. The system of 10, wherein the signal generator is external to a test and measurement instrument.

14. The system of 10, wherein the processor is located within a test and measurement instrument.

15. The system of 10, wherein the processor is external to a test and measurement instrument.

16. The system of 12, wherein the test and measurement instrument is a digital storage oscilloscope or spectrum analyzer.

17. The system of 10, wherein the signal generator is a step generator.

18. A test and measurement system, comprising: two de-embed probes configured to connect to a device under test and configured to take measurements of the device under test; and a processor configured to receive the measurements taken by the two de-embed probes and to determine the S-parameter set of the device under test based on the measurements of the device under test.

Having described and illustrated the principles of the disclosed technology in a preferred embodiment thereof, it should be apparent that the disclosed technology can be modified in arrangement and detail without departing from such principles. We claim all modifications and variations coming within the scope of the following claims.

**Claims**

1. A method for determining an S-parameter set of a device under test using a test and measurement instrument, comprising:

   measuring an impedance of a signal generator with a first de-embed probe;
   measuring an input voltage to the device under test with the first de-embed probe connected to the input of the device under test;
   measuring an output voltage from the device under test with a second de-embed probe connected to the output of the device under test;
   measuring three loads of the device under test with the first de-embed probe connected to the input of the device under test and the second de-embed probe connected to the output of the device under test; and
   calculating the S-parameter set of the device under test based on the impedance of the signal generator, the input voltage to and the output voltage from the device under test, and the measured three loads of the device under test.

2. The method of claim 1, wherein the measuring of the impedance of the signal generator with the first de-embed probe is performed with the device under test not connected to the first de-embed probe or the second de-embed probe.

3. The method of claim 1 or 2, wherein the measuring of the input voltage to the device under test with the first de-embed probe is performed with the device under test not connected to the second de-embed probe.

4. The method of any of claims 1 to 3, wherein the measuring of the output voltage from the device under test with the second de-embed probe is performed with the device under test and the signal generator not connected to the first de-embed probe.

5. The method of any of claims 1 to 4, wherein the measuring of the input voltage to the device under test and the measuring of the output voltage from the device under test are performed when the first de-embed probe is connected to the input of the device under test and when the second de-embed probe is simultaneously connected to the output of the device under test.

6. The method of any of claims 1 to 5, further comprising:

   measuring a second impedance of the device under test and the signal generator with the second de-embed probe; and

measuring a second output voltage of the device under test with the second de-embed probe connected to the output of the device under test and the signal generator,
wherein the calculating step further includes calculating the S-parameter set based on the second impedance and the second output voltage from the device under test.

7. The method of any of claims 1 to 6, wherein the test and measurement instrument is a digital storage oscilloscope or a spectrum analyzer.

8. The method of any of claims 1 to 7, wherein the signal generator is a step generator.

9. A method for determining an S-parameter set of a device under test with more than two ports using a test and measurement instrument, comprising:

performing the method of any of claims 1 to 8 on each two port combination of the more than two ports of the device under test, with the remaining ports terminated with a reference impedance; and
calculating the S-parameter set of the device under test based on the parameters determined for all the two port combinations.

10. A test and measurement system for measuring an S-parameters set of a device under test, comprising:

a signal generator;
a first de-embed probe configured to measure an impedance of the signal generator and an input voltage of the device under test;
a second de-embed probe configured to measure an output voltage of the device under test and an impedance of the device under test,
wherein the first de-embed probe and the second de-embed probe are configured to measure at least three loads when both the first de-embed probe and the second de-embed probe are connected to the device under test; and
a processor configured to calculate the S-parameter set of the device under test based on the impedance of the signal generator, the input voltage and the output voltage of the device under test, and the measured three loads of the device under test.

11. The system of claim 10, further including a test fixture including a first port and a second port, wherein the first de-embed probe connects to the signal generator and the device under test through the first port, and the second de-embed probe connects to the device under test through the second port.

12. The system of claim 10 or 11, wherein the signal generator is located within a test and measurement instrument.

13. The system of claim 10 or 11, wherein the signal generator is external to a test and measurement instrument.

14. The system of any of claims 10 to 13, wherein the processor is located within a test and measurement instrument or is external to a test and measurement instrument.

15. A test and measurement system, comprising:

two de-embed probes configured to connect to a device under test and configured to take measurements of the device under test; and
a processor configured to receive the measurements taken by the two de-embed probes and to determine an S-parameter set of the device under test based on the measurements of the device under test.

FIG. 1

FIG. 2

FIG. 3

FIG. 4

FIG. 5

FIG. 6

FIG. 7

FIG. 8

FIG. 9

**EUROPEAN SEARCH REPORT**

Application Number

EP 14 18 6464

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2007/041511 A1 (TAN KAN [US] ET AL) 22 February 2007 (2007-02-22) * figures 1-5, 10C, 11 * * paragraph [0005] - paragraph [0009] * * paragraph [0028] * * paragraph [0031] - paragraph [0038] * * paragraph [0041] - paragraph [0049] * * paragraph [0053] - paragraph [0067] * * paragraph [0092] * * paragraph [0094] - paragraph [0006] * ----- | 1-15 | INV. G01R35/00 G01R27/28 |
| X,D | US 7 405 575 B2 (TAN KAN [US] ET AL) 29 July 2008 (2008-07-29) * figures 1, 3-5, 9C, 10 * * column 2, line 42 - column 3, line 5 * * column 7, line 34 - column 19, line 9 * * column 20, line 37 - line 55 * ----- | 1-15 | |
| X | US 2004/075441 A1 (JECKO BERNARD JEAN YVES [FR] ET AL) 22 April 2004 (2004-04-22) * figures 1, 4-6 * * paragraph [0039] - paragraph [0060] * * paragraph [0092] - paragraph [0100] * ----- | 10-15 | TECHNICAL FIELDS SEARCHED (IPC) G01R |
| X,D A | US 2007/276614 A1 (TAN KAN [US] ET AL) 29 November 2007 (2007-11-29) * figures 1-4, 8A-8D * * paragraph [0025] - paragraph [0032] * * paragraphs [0042], [0045] * * paragraph [0049] - paragraph [0061] * * paragraph [0078] - paragraph [0080] * ----- -/-- | 10-15 1-9 | |

The present search report has been drawn up for all claims

| Place of search | Date of completion of the search | Examiner |
|---|---|---|
| Berlin | 18 February 2015 | Höller, Helmut |

EPO FORM 1503 03.82 (P04C01)

# EUROPEAN SEARCH REPORT

Application Number

EP 14 18 6464

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | PAUL D HALE ET AL: "A Statistical Study of De-Embedding Applied to Eye Diagram Analysis", IEEE TRANSACTIONS ON INSTRUMENTATION AND MEASUREMENT, IEEE SERVICE CENTER, PISCATAWAY, NJ, US, vol. 61, no. 2, 1 February 2012 (2012-02-01), pages 475-488, XP011391177, ISSN: 0018-9456, DOI: 10.1109/TIM.2011.2164853 * figures 1, 11, 12 * * chapter II. DECONVOLUTION * * APPENDIX A * | 1-15 | |
| A | EP 1 296 149 A1 (AGILENT TECHNOLOGIES INC [US]) 26 March 2003 (2003-03-26) * figures 1, 8 * * paragraph [0033] - paragraph [0071] * | 1-15 | |
| X | WO 88/08969 A1 (EIP MICROWAVE INC [US]) 17 November 1988 (1988-11-17) | 15 | TECHNICAL FIELDS SEARCHED (IPC) |
| A | * figure 1 * * page 2, line 15 - page 4, line 17 * | 1-14 | |
| A | ARKADIUSZ LEWANDOWSKI ET AL: "Covariance-Based Vector-Network-Analyzer Uncertainty Analysis for Time and Frequency-Domain Measurements", IEEE TRANSACTIONS ON MICROWAVE THEORY AND TECHNIQUES, IEEE SERVICE CENTER, PISCATAWAY, NJ, US, vol. 58, no. 7, 1 July 2010 (2010-07-01), pages 1877-1886, XP011311287, ISSN: 0018-9480 * figure 3 * * chapter: VII. APPLICATION EXAMPLES * | 1-15 | |

The present search report has been drawn up for all claims

| Place of search | Date of completion of the search | Examiner |
|---|---|---|
| Berlin | 18 February 2015 | Höller, Helmut |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 14 18 6464

This annex lists the patent family members relating to the patent documents cited in the above-mentioned European search report.
The members are as contained in the European Patent Office EDP file on
The European Patent Office is in no way liable for these particulars which are merely given for the purpose of information.

18-02-2015

| Patent document cited in search report | | Publication date | Patent family member(s) | | Publication date |
|---|---|---|---|---|---|
| US 2007041511 | A1 | 22-02-2007 | NONE | | |
| US 7405575 | B2 | 29-07-2008 | NONE | | |
| US 2004075441 | A1 | 22-04-2004 | AT | 268912 T | 15-06-2004 |
| | | | AU | 1614702 A | 18-06-2002 |
| | | | DE | 60103779 D1 | 15-07-2004 |
| | | | DE | 60103779 T2 | 14-07-2005 |
| | | | DK | 1342094 T3 | 18-10-2004 |
| | | | EP | 1342094 A1 | 10-09-2003 |
| | | | ES | 2223016 T3 | 16-02-2005 |
| | | | FR | 2817620 A1 | 07-06-2002 |
| | | | US | 2004075441 A1 | 22-04-2004 |
| | | | WO | 0246780 A1 | 13-06-2002 |
| US 2007276614 | A1 | 29-11-2007 | NONE | | |
| EP 1296149 | A1 | 26-03-2003 | DE | 60121951 T2 | 26-04-2007 |
| | | | EP | 1296149 A1 | 26-03-2003 |
| | | | JP | 2003179562 A | 27-06-2003 |
| | | | US | 2003057963 A1 | 27-03-2003 |
| WO 8808969 | A1 | 17-11-1988 | NONE | | |

EPO FORM P0459

For more details about this annex : see Official Journal of the European Patent Office, No. 12/82

**REFERENCES CITED IN THE DESCRIPTION**

**Patent documents cited in the description**

- US 20050185768 A1
- US 20050094746 A1
- US 20070276614 A1
- US 7405575 B2